(19) Europäisches Patentamt / European Patent Office / Office européen des brevets

(11) **EP 2 302 103 A1**

(12) **EUROPEAN PATENT APPLICATION**
published in accordance with Art. 153(4) EPC

(43) Date of publication:
**30.03.2011 Bulletin 2011/13**

(51) Int Cl.:
**C25D 1/04** (2006.01)   **C25D 1/00** (2006.01)
**C25D 3/38** (2006.01)

(21) Application number: **09762554.5**

(22) Date of filing: **12.06.2009**

(86) International application number:
**PCT/JP2009/060792**

(87) International publication number:
**WO 2009/151124 (17.12.2009 Gazette 2009/51)**

(84) Designated Contracting States:
**AT BE BG CH CY CZ DE DK EE ES FI FR GB GR HR HU IE IS IT LI LT LU LV MC MK MT NL NO PL PT RO SE SI SK TR**
Designated Extension States:
**AL BA RS**

(30) Priority: **12.06.2008 JP 2008154025**

(71) Applicants:
• **The Furukawa Electric Co., Ltd.**
  **Chiyoda-ku**
  **Tokyo 100-8322 (JP)**
• **Ishihara Chemical Co., Ltd.**
  **Kobe-shi**
  **Hyogo-ken 652-0806 (JP)**

(72) Inventors:
• **SAITO, Takahiro**
  **Tokyo 100-8322 (JP)**
• **SUZUKI, Yuji**
  **Tokyo 100-8322 (JP)**
• **IUCHI, Shoya**
  **Kobe-shi**
  **Hyogo 652-0806 (JP)**
• **NISHIKAWA, Tetsuji**
  **Kobe-shi**
  **Hyogo 652-0806 (JP)**

(74) Representative: **Thun, Clemens et al**
**Mitscherlich & Partner**
**Sonnenstraße 33**
**80331 München (DE)**

(54) **ELECTROLYTIC COPPER COATING AND METHOD OF MANUFACTURE THEREFOR, AND COPPER ELECTROLYTE FOR MANUFACTURING ELECTROLYTIC COPPER COATINGS**

(57)   An object of the present invention is to provide an electrolytic copper coating that exhibits a bendability and flexibility equal to or better than those of rolled copper foil after the heat history in a circuit board fabrication process, especially after a heat history equivalent to the heat history applied when bonding with a polyimide film. The present invention provides an electrolytic copper coating and a method of manufacturing the same wherein, when performing heat treatment so that the LMP value shown in Equation 1 becomes 9000 or more, the result becomes a crystal distribution of crystal grains, having a maximum length of crystal grains after heat treatment of 10 $\mu$m or more, of 70% or more:

$$\text{Equation 1: LMP = (T+273)*(20+Logt)}$$

where, 20 is a material constant of copper, T is temperature (°C), and t is time (hr).

EP 2 302 103 A1

**FIG.2A**

EXAMPLE1

LMP＝11500

**FIG.2B**

COMPARATIVE
EXAMPLE1

LMP＝11500

**Description**

Technical Field

The present invention relates to an electrolytic copper coating having superior bendability and flexibility, a method of manufacturing the same, and a copper electrolyte used for manufacturing the electrolytic copper coating. Note that, in this Description, "an electrolytic copper coating" is a general term covering a copper plating layer provided on a substrate in a printed circuit board, a multilayer printed circuit board, and a circuit board for chip-on films (below, these able to be generally referred to as a "circuit board"), a copper plating layer provided on a metal wire, and an electrolytic copper foil.

Background Art

Currently, due to the reduction in size of electrical products, the trend is toward the bending angles (R) of hinge parts of mobile phones becoming increasingly smaller.
The requirements on the bending characteristics of circuit boards are therefore becoming tougher. The important characteristics of copper foil for improving the bending characteristics are the thickness, surface smoothness, size of crystal grain, mechanical properties, etc. Further, to increase the density of wiring to deal with the reduction in size of electrical products, it is an important to use space as effectively as possible. Therefore, the use of a polyimide film, which enables a circuit board to easily deform, has become indispensable. The adhesive strength and the flexibility of the copper foil which is bonded on the polyimide film have become indispensable characteristics. A rolled copper foil produced by a special manufacturing process is used as copper foil satisfying these characteristics.
However, rolled copper foil suffers from the disadvantages that the manufacturing process is long, so the processing cost is high, copper foil having a wide width cannot be produced, and production of thin foil is difficult. Therefore, electrolytic copper foil satisfying the above-mentioned characteristics is being demanded. Further, in a circuit board, thick plating is performed at the time of forming circuits. Flexibility of the copper plating layer at the time of formation of a thick copper plating layer is also required. However, with the current copper plating technology, no electrolytic copper foil satisfying all the requirements while maintaining the smoothness of electrolytic copper foil and its production method has been proposed. No electrolytic copper coating (electrolytic copper foil or copper plating layer) having a flexibility and bendability equal to or better than those of above-mentioned rolled copper foil exists at present.

Summary of Invention

Technical Problem

The problem to be solved by the invention is to provide an electrolytic copper coating whose flexibility and bendability are equal to or better than those of rolled copper foil and to provide a method of manufacturing the same and a copper electrolyte used for manufacturing an electrolytic copper coating.

Solution to Problem

The electrolytic copper coating of the present invention comprises an electrolytic copper coating produced by electrolytic deposition, wherein, when performing heat treatment so that the LMP value shown in Equation 1 becomes 9000 or more, the result becomes a crystal distribution of crystal grains, having a maximum length of crystal grains after heat treatment of 10 $\mu$n or more, of 70% or more:

$$\textbf{Equation 1: LMP = (T+273)*(20+Logt)}$$

where, 20 is a material constant of copper, T is temperature (°C), and t is time (hr).
Preferably, when the electrolytic copper coating is heat treated to give an LMP value of 9000 or more, the 0.2% proof stress of the electrolytic copper coating is less than 10 kN/cm$^2$, and the Young's modulus is less than 2000 kN/cm$^2$.
Preferably, when the electrolytic copper coating is heat treated to give an LMP value of 9000 or more, the Vickers hardness of the electrolytic copper coating is less than 60Hv.
Preferably, in SIMS (secondary ion mass spectrometry) analysis of the electrolytic copper coating in the copper coating depth direction, in terms of the strength ratio with the copper (Cu), the content of chlorine (Cl) is less than 0.5%, the content of nitrogen (N) is less than 0.005%, and the content of sulfur (S) is less than 0.005%.

Preferably, a roughness of at least one surface of the electrolytic copper coating is less than 0.30 μm in terms of Ra and less than 2.0 μm in terms of Rz prescribed in JIS-B-0601.

A method of manufacturing an electrolytic copper coating of the present invention comprises a method of manufacturing an electrolytic copper coating produced by electrolytic deposition using a copper electrolyte, wherein, when performing heat treatment so that the LMP value shown in Equation 1 becomes 9000 or more, the result becomes a crystal distribution of crystal grains, having a maximum length of crystal grains after heat treatment of 10 μm or more, of 70% or more.

$$\text{Equation 1: LMP = (T+273)*(20+Logt)}$$

where, 20 is a material constant of copper, T is temperature (°C), and t is time (hr).

Preferably, the copper electrolyte contains at least one type of reaction product of at least one type of di- or poly-halogenated chain saturated aliphatic hydrocarbon compound, at least one type of di- or poly-halogenated chain saturated aliphatic hydrocarbon compound which has one or more ether bonds, or a combination of at least one type of di- or poly-halogenated chain saturated aliphatic hydrocarbon compound and at least one type of dior poly-halogenated chain saturated aliphatic hydrocarbon compound which has one or more ether bonds with a heterocyclic compound which has two nitrogen atoms.

Preferably, the copper electrolyte contains at least one type of reaction product of at least one type of di- or poly-halogenated chain saturated aliphatic hydrocarbon compound, at least one type of di- or poly-halogenated chain saturated aliphatic hydrocarbon compound which has one or more ether bonds, or a combination of at least one type of di- or poly-halogenated chain saturated aliphatic hydrocarbon compound and at least one type of dior poly-halogenated chain saturated aliphatic hydrocarbon compound which has one or more ether bonds with a heterocyclic compound which has two nitrogen atoms and contains at least one type of brightener.

Preferably, the heterocyclic compound which has two nitrogen atoms is a heterocyclic aromatic compound which has two nitrogen atoms.

Preferably, the copper electrolyte contains at least one type of reaction product of a di- or poly-halogenated chain saturated aliphatic hydrocarbon compound or a di- or poly-halogenated chain saturated aliphatic hydrocarbon compound which has one or more ether bonds with a heterocyclic compound which has two nitrogen atoms and contains at least one type of brightener.

Preferably, the copper electrolyte contains at least one type of reaction product of at least one type of di- or poly-halogenated chain saturated aliphatic hydrocarbon compound, at least one type of di- or poly-halogenated chain saturated aliphatic hydrocarbon compound which has one or more ether bonds, or a combination of at least one type of di- or poly-halogenated chain saturated aliphatic hydrocarbon compound and at least one type of dior poly-halogenated chain saturated aliphatic hydrocarbon compound which has one or more ether bonds with a heterocyclic compound which has two nitrogen atoms.

Preferably, the copper electrolyte contains at least one type of reaction product of at least one type of di- or poly-halogenated chain saturated aliphatic hydrocarbon compound, at least one type of di- or poly-halogenated chain saturated aliphatic hydrocarbon compound which has one or more ether bonds, or a combination of at least one type of di- or poly-halogenated chain saturated aliphatic hydrocarbon compound and at least one type of dior poly-halogenated chain saturated aliphatic hydrocarbon compound which has one or more ether bonds with a heterocyclic compound which has two nitrogen atoms and contains at least one type of brightener.

Advantageous Effects of Invention

The present invention can provide an electrolytic copper coating that exhibits flexibility and bendability equal to or better than those of rolled copper foil after the heat history in a circuit board fabrication process, especially after a heat history that is equivalent to the heat history applied when bonding with a polyimide film. Further, the present invention can provide a circuit board having flexibility and bendability using an electrolytic copper coating at a lower cost compared with rolled copper foil.

Furthermore, the present invention can provide a copper electrolyte for manufacturing an electrolytic copper coating which exhibits flexibility and bendability equal to or better than those of rolled copper foil after the heat history in a circuit board fabrication process, especially after a heat history that is equivalent to the heat history applied when bonding with a polyimide film.

Brief Description of Drawings

[FIG. 1] FIG. 1 is a view explaining a drum type foil manufacturing apparatus.
[FIG. 2] FIG. 2 gives electron micrographs of cross-sections of copper foils, wherein FIG. 2A is a cross-sectional photograph of Example 1 in the present invention while FIG. 2B is a cross-sectional photograph of Comparative Example 1.
[FIG. 3] FIG. 3 gives charts of the SIMS analysis results, wherein FIG. 3A is a chart of Example 1 in the present invention while FIG. 3B is a chart of Comparative Example 1.
[FIG. 4] FIG. 4A shows the circuit pattern of an IPC flex test sample, while FIG. 4B shows an IPC flex test sample.

Embodiments of Invention

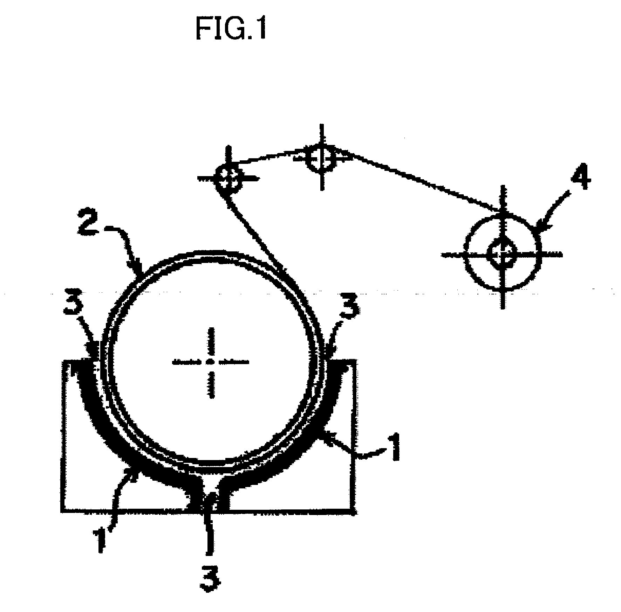

Below, using an electrolytic copper foil, one type of electrolytic copper coating, as an example, an embodiment of the present invention will be explained in detail. A usual electrolytic copper foil is for example produced by an electrolytic foil manufacturing apparatus shown in FIG. 1. The electrolytic foil manufacturing apparatus is comprised of a rotating drum shaped cathode 2 (surface made of SUS or titanium) and an anode 1 (lead or precious metal oxide-coated titanium electrode) arranged concentrically with the cathode 2. The electrolytic foil manufacturing apparatus is supplied with an electrolyte 3 while a current is run across the two electrodes so as to electrolytically deposit copper to a predetermined thickness on the surface of the cathode 2, then the copper is peeled off from the surface of the cathode 2 in the form of foil. The copper foil at this stage is sometimes called untreated electrolytic copper foil 4. Further, the surface of the untreated electrolytic copper foil 4 which contacted the electrolyte is called as the "matte-side surface", while the surface which contacted the rotating drum-shaped cathode 2 is called the "shiny-side surface". Note that, above, an electrolytic foil manufacturing apparatus employing a rotating cathode 2 was explained, but the copper foil may also be produced by an electrolytic foil manufacturing apparatus using a plate shaped cathode.

The surface roughness of the electrolytic copper foil just after production is the surface roughness of the cathode transferred to it, so it is preferable to use a cathode whose surface roughness is Ra: 0.01 to 0.3 $\mu$m and Rz: 0.1 to 2.0 $\mu$m as the cathode for electrodeposition of copper. By using such a cathode, the surface roughness of the shiny side of the electrolytic copper foil just after production, to which the cathode surface is transferred, can be made Ra: 0.01 to 0.3 $\mu$m and Rz: 0.1 to 2.0 $\mu$m. Production of electrolytic copper foil with a surface roughness Ra of the shiny side of less than 0.01 $\mu$m and/or Rz of less than 0.1 $\mu$m, considering the technology for polishing cathodes etc., is difficult. Further, this is unsuitable for mass production. Further, if the surface roughness Ra of the shiny side is made 0.3 $\mu$m or more and/or the Rz is made 2.0 $\mu$m or more, the bending characteristics of the electrolytic copper foil deteriorate and the characteristics sought by the present invention are no longer obtained.

The surface roughness of the matte side of the electrolytic copper foil is preferably an Ra of 0.01 to 0.2 $\mu$m and an Rz of 0.05 to 1.5 $\mu$m. A surface roughness of an Ra of less than 0.01 $\mu$m and/or an Rz of less than 0.05 $\mu$m is extremely difficult even if bright plating is performed. In practice, manufacture is close to impossible. Further, in the above way, if the surface of the electrolytic copper foil is rough, the bending characteristics deteriorate, so the upper limit of the roughness is preferably made an Ra of less than 0.2 $\mu$m and an Rz of less than 1.5 $\mu$m. A surface roughness of the shiny side and/or the matte side of an Ra of less than 0.2 $\mu$m and an Rz of less than 1.0 $\mu$m is more preferable.

Further, the thickness of the electrolytic copper foil is preferably 3 $\mu$m to 70 $\mu$m. This is because manufacture of copper foil of a thickness of less than 3 $\mu$m is difficult due to handling technology etc. and is not practical. The upper limit of the thickness is about 70 $\mu$m from the viewpoint of the current state of use of circuit boards. This is because it is difficult to conceive of electrolytic copper foil of a thickness of 70 $\mu$m or more being used as copper foil for circuit boards. Further, there is no cost benefit to using electrolytic copper foil.

Further, as the copper electrolyte for depositing the electrolytic copper foil, there are a copper sulfate plating solution, copper pyrophosphate plating solution, copper sulfamate plating solution, etc. Considering costs etc., a copper sulfate plating solution is preferable.

The copper sulfate plating solution preferably has a sulfuric acid concentration of 20 to 150 g/L, especially 30 to 100 g/L. If the sulfuric acid concentration is less than 20 g/L, the flow of current becomes harder, so practical operation becomes difficult. Further, the uniformity of plating and electrodeposition performance also become poorer. If the sulfuric acid concentration is more than 150 g/L, the copper solubility decreases, so a sufficient copper concentration can no longer be obtained and practical operation becomes difficult. Further, the corrosion of equipment is promoted.

The copper concentration is preferably 40 to 150 g/L, especially 60 to 100 g/L. If the copper concentration becomes less than 40 g/L, it is difficult to secure the current density at which practical operation is possible in manufacturing electrolytic copper foil. A copper concentration of more than 150 g/L requires a considerably high temperature and therefore is impractical.

The current density is preferably 20 to 200A/dm$^2$, especially 30 to 120A/dm$^2$. If the current density becomes less than 20A/dm$^2$, in the manufacture of electrolytic copper foil, the production efficiency is extremely low, so this is impractical. A current density of more than 200A/dm$^2$ requires a considerably high copper concentration, high temperature, and high flow velocity, and the production equipment of the electrolytic copper foil is subjected to a high load, so this is impractical.

The electrolytic bath temperature is preferably 25 to 80°C, especially 30 to 70°C. If the bath temperature becomes less than 25°C, in the manufacture of the electrolytic copper foil, it is difficult to secure a sufficient copper concentration and current density, so this is impractical. Further, a bath temperature of more than 80°C is extremely difficult in terms of operation and equipment, so this is impractical.

In this embodiment, the electrolyte has chlorine added to it if necessary. The chlorine concentration is preferably 1 to 100 ppm, especially 10 to 50 ppm. If the chlorine concentration becomes less than 1 ppm, it becomes difficult to obtain the effect of the later described additives. If more than 100 ppm, normal plating becomes difficult. The electrolysis conditions are suitably adjusted to conditions where problems such as deposition of copper and burning of plating do not occur within each range.

In the copper sulfate plating bath for manufacturing the electrolytic copper foil, a reaction product of at least one type of di- or poly-halogenated chain saturated aliphatic hydrocarbon compound, at least one type of di- or poly-halogenated chain saturated aliphatic hydrocarbon compound which has one or more ether bonds, or a combination of at least one type of di- or poly-halogenated chain saturated aliphatic hydrocarbon compound and at least one type of di- or poly-halogenated chain saturated aliphatic hydrocarbon compound which has one or more ether bonds with a heterocyclic compound which has two nitrogen atoms is added as a leveler.

The number of carbon atoms of the di- or poly-halogenated chain saturated aliphatic hydrocarbon compound is in general 1 to 30, preferably 2 to 18, more preferably 4 to 8. Specifically, 1,3-dichloro-2-propanol, 1,4-dichloro-2,3-butanediol, 1-bromo-3-chloroethane, 1-chloro-3-iodoethane, 1,2-diiodoethane, 1,3-dichloropropane, 1,2,3-trichloropropane, 1-bromo-3-chloropropane, 1,3-dibromopropane, 1,2-dichloroethane, 1-chloro-3-iodopropane, 1,4-dichloro-2-butanol, 1,2-dibromoethane, 2,3-dichloro-1-propanol, 1,4-dichlorocyclohexane, 1,3-diiodopropane, 1-bromo-3-chloro-2- methylpropane, 1,4-dichlorobutane, 1,4-dibromobutane, 1,5-dichloro[3-(2-chloroethyl)]pentane, 1,6-dibromohexane, 1,8-dichlorooctane, 1,10-dichlorodecane, 1,18-dichlorooctadecane, etc. can be mentioned. These compounds are used alone or in combinations of a plurality of types.

The number of carbon atoms of the di- or poly-halogenated chain saturated aliphatic hydrocarbon compound which has one or more ether bonds is 4 to 30, preferably 4 to 12, more preferably 6 to 10. Specifically, 2,2'-dichloroethyl ether, 1,2-bis(2-chloroethoxy)ethane, diethyleneglycol-bis(2-chloroethyl)ether, triethylene glycol-bis(2-chloroethyl) ether, 2,2'-dichloropropyl ether, 2,2'-dichlorobutyl ether, tetraethylene glycol-bis(2-bromoethyl)ether, heptaethylene glycol-bis(2-chloroethyl)ether, tridecaethylene glycol-bis (2-bromoethyl)ether, etc. can be mentioned. These compounds are used alone or in combinations of a plurality of types.

As the heterocyclic compound which has two nitrogen atoms, piperazine, triethylenediamine, 2-methylpiperazine, 2,6-dimethylpiperazine, 2,5-dimethylpiperazine, homopiperazine, 2-pyrazoline, imidazole, 2-methylimidazole, 2-ethylimidazole, 2-propylimidazole, 4-methylimidazole, histidine, 1-(3-aminopropyl)imidazole, 2-imidazoline, 3-imidazoline, 4-imidazoline, 2-methyl-2-imidazoline, pyrazole, 1-methylpyrazole, 3-methylpyrazole, 1,3-dimethylpyrazole, 1,4-dimethylpyrazole, 1,5-dimethylpyrazole, 3,5-dimethylpyrazole, benzimidazole, indazole, piperazine, 2-methylpiperazine, 2,5-dimethylpiperazine, pyrimidine, pyridazine, etc. can be mentioned. These compounds are used alone or in combinations of a plurality of types. In particular, 2-pyrazoline, pyrazole, imidazole, 2-methylimidazole, 2-imidazoline, 3-imidazoline, 4-imidazoline, 2-methyl-2-imidazoline, etc. are preferable. In the present invention, a reaction product of a combination of a di- or poly-halogenated chain saturated aliphatic hydrocarbon compound and a di- or poly-halogenated chain saturated aliphatic hydrocarbon compound which has one or more ether bonds with a heterocyclic compound which has two nitrogen atoms can be used. Furthermore, a reaction product comprised of the above-mentioned starting material compound to which dimethylamine, diethanolamine, ethylenediamine, or another aliphatic amino compound, phenylenediamine or another aromatic amino compound, succinyl chloride, glutaryl chloride, fumaryl chloride, dichloroxylylene, phthaloyl chloride, or another compound which has a plurality of reactive groups is added and reacted as a third material can be used. However, use of epichlorohydrin or another epihalohydrin compound as the third reaction component is not preferable because the expected effect of the reaction product cannot be obtained.

The reaction temperature for producing the reaction product of a di- or poly-halogenated chain saturated aliphatic hydrocarbon compound or di- or poly-halogenated chain saturated aliphatic hydrocarbon compound which has one or more ether bonds with a heterocyclic compound which has two nitrogen atoms is from room temperature to 200°C, preferably 50°C to 130°C.

The reaction time for producing the reaction product of a di- or poly-halogenated chain saturated aliphatic hydrocarbon compound or di- or poly-halogenated chain saturated aliphatic hydrocarbon compound which has one or more ether bonds with a heterocyclic compound which has two nitrogen atoms is 1 hour to 100 hours, preferably 3 hours to 50 hours.

The reaction for producing the above reaction product of a di- or poly-halogenated chain saturated aliphatic hydrocarbon compound or di- or poly-halogenated chain saturated aliphatic hydrocarbon compound which has one or more ether bonds with a heterocyclic compound which has two nitrogen atoms can be performed without a solvent, but a solvent may also be used. As the solvent, methanol, ethanol, 1-propanol, isopropanol, t-butanol, 1-butanol, and other alcohols, dimethylformamide, dioxane, tetrahydrofuran, methyl cellosolve, ethyl cellosolve, dimethyl cellosolve, diethyl cellosolve, etc. may be used.

During the reaction for producing the above reaction product of a di- or poly-halogenated chain saturated aliphatic hydrocarbon compound or di- or poly-halogenated chain saturated aliphatic hydrocarbon compound which has one or more ether bonds with a heterocyclic compound which has two nitrogen atoms, a halogen may be generated. During the reaction, this halogen may be contained, but preferably the halogen is removed by a well known method, for example, an ion exchange method, a method of insolubilizing it as alkaline metal halide by a reaction with an alkali metal hydroxide etc. The selection of whether the reaction product should be allowed to contain a halogen is made so as to satisfy the required performance as a copper electrolyte.

As the brightener which is used in the present embodiment, one may be suitably selected from known ones. For example, 3-mercaptopropane sulfonic acid and its salt, bis(3-sulfopropyl)disulfide and its salt, N,N-dimethyldithiocarbamic acid (3-sulfopropyl)ester, N,N-dimethyldithiocarbamic acid (3-sulfoethyl)ester, sodium 3-(benzothiazolylthio) ethyl sulfonate, pyridiniumpropyl sulfobetaine, etc. can be mentioned.

When adding a polymer to the copper electrolyte, the polymer may be suitably selected from known ones. For example, a molecular weight 200 or greater polyethyleneglycol, polypropyleneglycol, copolymer of polyethyleneglycol and polypropyleneglycol, C1 to C6 alkyl monoether of the above three types of glycols, polyoxyethylene glyceryl ether, polyoxypropylene glyceryl ether, polyoxyethylene polyoxypropylene glyceryl ether, etc. can be mentioned. Especially, one of a molecular weight of 500 to 100,000 is preferable.

In the copper of the electrolytic copper foil produced by the above-mentioned conditions, the contents of elements taken in from the plating solution and additive ingredients such as chlorine (Cl), nitrogen (N), and sulfur (S) are preferably, in terms of intensity ratio with copper (Cu) in SIMS (secondary ion mass spectrometry) analysis of different parts in the copper foil depth direction, chlorine (Cl) of less than 0.5%, nitrogen (N) of less than 0.005%, and sulfur (S) of less than 0.005%. Furthermore, more preferably, the oxygen (O) is less than 1% and the carbon (C) less than 0.1%.

The electrolytic copper foil of the present embodiment is an electrolytic copper foil in which there are few impurities as a whole and in which there are not many partially either (impurities are averagely distributed). Therefore, the electrolytic copper foil of the present embodiment, when subjected to the heat history in the circuit board fabrication process, especially a heat history that is equivalent to the heat history applied when bonding with a polyimide film, can be given flexibility and bendability equal to or better than those of rolled copper foil because the impurities are low and therefore grain coarsening progresses easily.

The electrolytic copper foil produced as above, when heat treated so that the LMP value shown in Equation 1 (hereinafter, simply described the "LMP value") becomes 9000 or more, becomes an electrolytic copper foil which has a crystal distribution of 70% or more of crystal grains having a maximum length of the crystal grains after heat treatment of 10 $\mu$m or more. Preferably, the heat treatment is performed so that a LMP value becomes 11,000 or more.

$$\texttt{Equation 1: LMP=(T+273)*(20+Logt)}$$

where, 20 is the material constant of copper, T is the temperature (°C), and t is the time (hr).

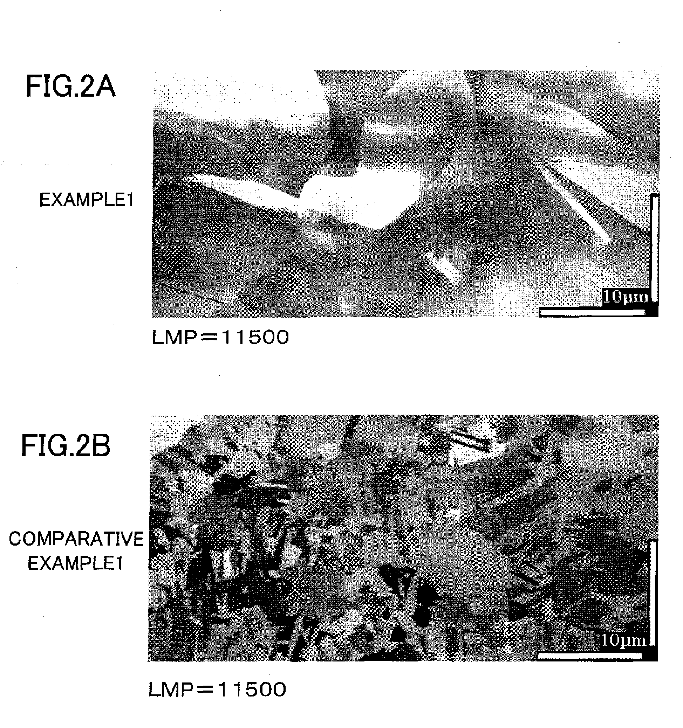

FIG. 2 gives examples of electron micrographs of the cross-sectional surfaces of electrolytic copper foils, wherein FIG. 2A is a cross-sectional photograph of the electrolytic copper foil of this embodiment, and FIG. 2B is a cross-sectional photograph of a conventional electrolytic copper foil. The maximum length of the crystal grains is measured by the method of measuring the lengths of crystal grains in the long axis direction in a 1000 $\mu$m$^2$ area of a micrograph capturing a cross-section of the electrolytic copper foil, measuring the area occupied by crystal grains of a length of 10 $\mu$m or more, and calculating what percent the measured area is of the area of the cross-section as a whole.

The 0.2% proof stress of the copper foil after the above heat treatment is preferably less than 10 kN/cm$^2$, and the Young's modulus is preferably less than 2000 kN/cm$^2$. Note that the 0.2% proof stress is optimally less than 8 kN/cm$^2$.

Above, the present invention was explained with reference to an electrolytic copper foil, but it may also be a copper plating layer provided on a substrate in a printed circuit board or a copper plating layer provided on a metal wire. That is, a thick plating provided on a copper laminated substrate after etching, a thick plating provided on an organic film after forming a thin film by sputtering or non-electrolytic plating, and a copper plating layer provided on a metal plate or wire may also be formed by the copper electrolyte of the present invention. Note that, in many cases, a copper plating layer is formed on a metal thin film as explained above, so copper plating is generally performed at low current density conditions compared with electrolytic copper foil. Therefore, the preferred ranges of copper concentration, current density, and electrolyte temperature differ from those of an electrolytic copper foil. The preferred range of copper concentration is 30 to 70 g/L, the preferred range of current density is 0.1 to 15 A/dm$^2$, and the preferred range of electrolyte temperature is 20 to 50°C. Further, in a copper plating layer, sometimes the hardness becomes a problem. When performing the above heat treatment of the copper plating layer, the Vickers hardness is preferably less than 60Hv.

Examples

Below, the present invention will be explained with reference to examples, but the present invention is not limited to these.

Foil-Making

Examples 1 to 13 and Comparative Examples 1 to 6

Table 1 shows the electrolyte composition. A copper sulfate plating solution of each composition shown in Table 1 (below, sometimes referred to as an "electrolyte") was run through an activated charcoal filter to purify it, then the additives shown in Table 2 were added to predetermined concentrations. Next, an 18 μm thick electrolytic copper foil was deposited on a rotating drum made of titanium shown in FIG. 1 from the copper sulfate plating solution by the current density shown in Table 1, then was peeled off and rolled up.

Examples 14 to 26 and Comparative Examples 7 to 12

In the same way, a copper sulfate plating solution of each composition shown in Table 1 was run through an activated charcoal filter, then the additives shown in Table 2 were added to predetermined concentrations. Next, an 18 μm thick copper plating layer was deposited on a 1 μm thick non-electrolytic copper plating layer prepared on a 25 μm thick polyimide film beforehand, from the copper sulfate plating solution by the current density shown in Table 1.

Table 1

|  |  | Copper sulfate plating solution | | |  |
| --- | --- | --- | --- | --- | --- |
|  | Form | Copper (g/L) | Sulfuric acid (g/L) | Temperature (°C) | Current density (A/dm$^2$) |
| Ex. 1 to13 | Electrolytic copper foil | 90 | 50 | 60 | 60 |
| Ex. 14 to 26 | Copper plating layer | 50 | 50 | 30 | 5 |
| Comp. Ex. 1 to 6 | Electrolytic copper foil | 90 | 50 | 60 | 60 |
| Comp. Ex. 7 to 12 | Copper plating layer | 50 | 50 | 30 | 5 |

Table 2

|  | Leveler | | Brightener | | Polymer | | Chlorine |
| --- | --- | --- | --- | --- | --- | --- | --- |
|  | Type | Concentration (ppm) | Type | Concentration (ppm) | Type | Concentration (ppm) | Concentration (ppm) |
| Ex. 1 | (1) | 10 | MPS | 1 | PEG (MW2000) | 100 | 25 |
| Ex. 2 | (1) | 1000 | MPS | 1 | PEG (MW2000) | 50 | 25 |
| Ex. 3 | (1) | 1000 | MPS | 1 | None | - | 25 |
| Ex. 4 | (2) | 100 | SPS | 20 | None | - | 25 |

(continued)

|  | Leveler | | Brightener | | Polymer | | Chlorine |
|---|---|---|---|---|---|---|---|
|  | Type | Concentration (ppm) | Type | Concentration (ppm) | Type | Concentration (ppm) | Concentration (ppm) |
| Ex. 5 | (3) | 5 | SPS | 10 | (8) | 200 | 25 |
| Ex. 6 | (4) | 100 | (6) | 10 | None | - | 25 |
| Ex. 7 | (5) | 10 | (7) | 20 | None | - | 25 |
| Ex. 8 | (1) | 1000 | MPS | 1 | PEG (MW2000) | 50 | 25 |
| Ex. 9 | (1) | 1000 | MPS | 1 | None | - | 25 |
| Ex. 10 | (2) | 100 | SPS | 20 | None | - | 25 |
| Ex. 11 | (1) | 1000 | MPS | 1 | PEG (MW2000) | 50 | 25 |
| Ex. 12 | (1) | 1000 | MPS | 1 | None | - | 25 |
| Ex. 13 | (2) | 100 | SPS | 20 | None | - | 25 |
| Ex. 14 | (1) | 10 | MPS | 1 | PEG (MW2000) | 100 | 25 |
| Ex. 15 | (1) | 1000 | MPS | 1 | PEG (MW2000) | 50 | 25 |
| Ex. 16 | (1) | 1000 | MPS | 1 | None | - | 25 |
| Ex. 17 | (2) | 100 | SPS | 20 | None | - | 25 |
| Ex. 18 | (3) | 5 | SPS | 10 | (8) | 200 | 25 |
| Ex. 19 | (4) | 100 | (6) | 10 | None | - | 25 |
| Ex. 20 | (5) | 10 | (7) | 20 | None PEG | - | 25 |
| Ex. 21 | (1) | 1000 | MPS | 1 | (MW2000) | 50 | 25 |
| Ex. 22 | (1) | 1000 | MPS | 1 | None | - | 25 |
| Ex. 23 | (2) | 100 | SPS | 20 | None | - | 25 |
| Ex. 24 | (1) | 1000 | MPS | 1 | PEG (MW2000) | 50 | 25 |
| Ex. 25 | (1) | 1000 | MPS | 1 | None | - | 25 |
| Ex. 26 | (2) | 100 | SPS | 20 | None | - | 25 |
| Comp. Ex. 1 | Low molecular weight glue | 80 | MPS | 1 | PEG (MW2000) | 100 | 25 |
| Comp. Ex. 2 | Low molecular weight glue | 80 | SPS | 10 | (8) | 200 | 25 |
| Comp. Ex. 3 | None | - | None | - | None | - | 0 |
| Comp. Ex. 4 | (1) | 1000 | MPS | 1 | PEG (MW2000) | 50 | 25 |

(continued)

| | Leveler | | Brightener | | Polymer | | Chlorine |
| | Type | Concentration (ppm) | Type | Concentration (ppm) | Type | Concentration (ppm) | Concentration (ppm) |
|---|---|---|---|---|---|---|---|
| Comp. Ex. 5 | (1) | 1000 | MPS | 1 | None | - | 25 |
| Comp. Ex. 6 | (2) | 100 | SPS | 20 | None | - | 25 |
| Comp. Ex. 7 | Low molecular weight glue | 80 | MPS | 1 | PEG (MW2000) | 100 | 25 |
| Comp. Ex. 8 | Low molecular weight glue | 80 | SPS | 10 | (8) | 200 | 25 |
| Comp. Ex. 9 | None | - | None | - | None | - | 0 |
| Comp. Ex. 10 | (1) | 1000 | MPS | 1 | PEG (MW2000) | 50 | 25 |
| Comp. Ex. 11 | (1) | 1000 | MPS | 1 | None | - | 25 |
| Comp. Ex. 12 | (2) | 100 | SPS | 20 | None | - | 25 |

Regarding Each Compound

Leveler

(1): Reaction product of 1,4-dichloro-2-buthanol and 2-pyrazoline
(2): Reaction product of 2,2'-dichloroethyl ether and 2-imidazoline
(3): Reaction product of 1,3-dichloro-2-propanol and imidazole
(4): Reaction product of 1,3-dichloropropane and 2-methyl-2-imidazoline
(5): Reaction product of 1,3-dibromopropane and piperazine Brightener
MPS: 3-mercaptopropanesulfonic acid
SPS: Sodium bis(3-sulfopropyl)disulfide
(6): Sodium N,N-dimethyldithiocarbamate
(7): Sodium 3-(benzothiazolyl-2-thio)propylsulfonate Polymer
PEG: Polyethylene glycol (molecular weight 2000)
(8): Polyethylene glycol-polypropylene glycol copolymer

The produced electrolytic copper foil and copper plating layer were respectively divided into three samples. Among these, one sample each was used to measure the amounts of impurity elements contained inside the electrolytic copper foil and the copper plating layer and the surface roughness. Further, another unused sample of each was heat-treated and observed for crystal grains at the cross-section. Furthermore, a sample of the electrolytic copper foil was tested for tensile strength, while a sample of the copper plating layer was tested for Vickers hardness. Finally, for each remaining unused sample, the sample of the electrolytic copper foil was hot pressed with a polyimide film, then the sample of the copper plating layer was heat-treated by the same temperature setting, then these samples were tested by an IPC bending test. The details of each measurement and examination are described below.

Measurement of Amounts of Impurity Elements

The amounts of impurity elements inside the electrolytic copper foils and copper plating layers of Examples 1 to 7, Examples 14 to 20, Comparative Examples 1 to 3, and Comparative Examples 7 to 9 were measured in the depth direction using SIMS analysis. The measured elements were oxygen (O), carbon (C), chlorine (Cl), nitrogen (N), and sulfur (S). The measurement conditions of the SIMS analysis were as follows.

Primary ions: $Cs^+$ (5 kV, 100nA)
Secondary (detection) ions: Copper $(Cu)^{63}Cu^-$, Chlorine $(Cl)^{35}Cl^-$, Nitrogen $(N)^{14}N+^{63}Cu^-$, Sulfur $(S)^{34}S^-$, Oxygen $(O)^{16}O^-$, Carbon $(C)^{12}C^-$
Sputtered domain: 200 $\mu$m x 400 $\mu$m

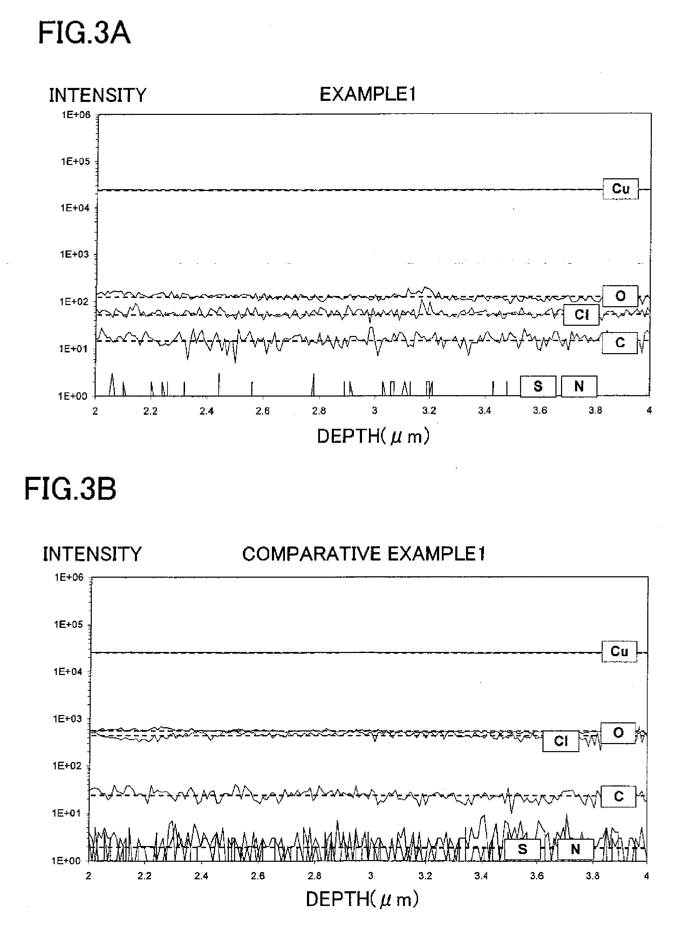

The surfaces of the electrolytic copper foils and copper plating layers are affected by dirt and oxide layers, so the portions from the surfaces to 2 $\mu$m down in the depth direction were removed by sputtering, then the measurement was started and the portion down to a depth of 4 $\mu$m was analyzed. The intensity ratio was calculated from the average value of the intensity of each measured element and the average value of the intensity of copper. Examples of the measurement results of the SIMS analysis are shown in FIG. 3A and FIG. 3B, while the calculation results of the intensity ratio are shown in Table 3.

Measurement of Surface Roughness

The surface roughnesses Ra and Rz of the electrolytic copper foils and the copper plating layers of Examples 1 to 7, Examples 14 to 20, Comparative Examples 1 to 3, and Comparative Examples 7 to 9 were measured using a contact type surface roughness gauge. The surface roughness is shown by Ra (arithmetic average roughness) and Rz (ten-point average roughness) defined in JIS-B-0601 (Japanese Industrial Standard). The reference length is 0.8 mm. The electrolytic copper foils were measured for the Ra and Rz of the matte-side surfaces and shiny-side surfaces and the copper plating layers were measured for the Ra and Rz of the surfaces of the copper plating layers and the non-electrolytic copper layer surfaces before plating. The results of surface roughness measurement are described in Table 3.

Heating Conditions

The electrolytic copper foils and the copper plating layers of Examples 1 to 7, Examples 14 to 20, Comparative Examples 1 to 3, and Comparative Examples 7 to 9 were heat-treated in a nitrogen atmosphere under heating conditions of 300°C and 1 hour giving an LMP value of Equation 1 of 9000 or more (LMP value=11,500). Similarly, the electrolytic copper foils and the copper plating layers of Examples 8 to 10 and Examples 21 to 23 were heat-treated in a nitrogen atmosphere under heating conditions of 250°C and 1 hour giving an LMP value of 9000 or more (LMP value=10,500). Furthermore, the electrolytic copper foils and the copper plating layers of Examples 11 to 13 and Examples 24 to 26 were heat-treated in a nitrogen atmosphere under heating conditions of 200°C and 1 hour giving an LMP value of 9000 or more (LMP value=9500). Finally, the electrolytic copper foils and the copper plating layers of Comparative Examples 4 to 6 and Comparative Examples 10 to 12 were heat-treated in a nitrogen atmosphere under heating conditions of 130°C and 1 hour giving an LMP value of less than 9000 (LMP value=8100). Observation of Crystal Grains at Cross-Section
After the electrolytic copper foils and the copper plating layers of the examples and the comparative examples were heat-treated by the above heating conditions, the cross-sections of the copper coatings were photographed by an electron micrograph, then the ratios of the crystals grains with maximum lengths of 10 $\mu$m or more is measured and calculated in an area of 1000 $\mu m^2$. The results of the observation of the crystal grains at the cross-section are described in Table 4.

Tensile Test

After the electrolytic copper foils of Examples 1 to 13 and Comparative Examples 1 to 6 were heat-treated under the above heat conditions, the foils were cut into 6 inch (length) x 0.5 inch (width) test pieces which were then measured for 0.2% proof stress and Young's modulus using a tensile tester. Further, the tension rate was 50 mm/min. The results of the tensile test are described in Table 4. The 0.2% proof stress is the value obtained in the curve of the relationship of strain and stress by drawing a tangent to the curve at the point of 0% strain, drawing a line parallel to that tangent at the point of 0.2% strain, and dividing the stress at the point where that line and the curve intersect by the cross-sectional area. Measurement of Vickers Hardness
The electrolytic plating layers of Examples 14 to 26 and Comparative Examples 7 to 12 were heat-treated under the above heating conditions, then the copper plating layers were embedded in a resin, the cross-sections were cut, then the cross-sections were polished and a Vickers hardness tester was used to measure the Vickers hardness. Further, the load was 10 gf and load holding time was 15 sec. The results of the Vickers hardness test are described in Table 4.

IPC Flex Test Characteristics

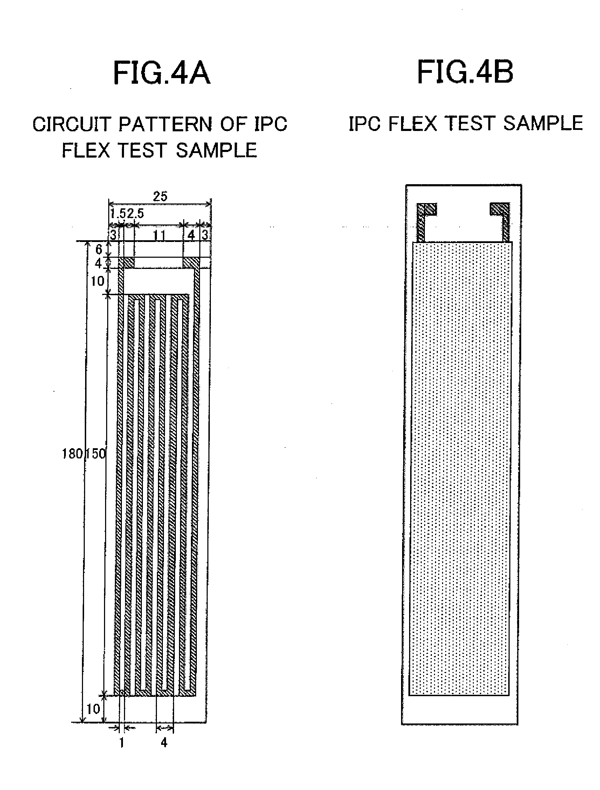

The electrolytic copper foils of Examples 1 to 7 and Comparative Examples 1 to 3 and 25 $\mu$m thick polyimide films were press bonded under heating conditions of 330°C and 20 minutes (LMP value=11,800) to prepare electrolytic copper foils to which polyimide films were bonded. Furthermore, the copper plating layers on 25 $\mu$m thick polyimide films of Examples 14 to 20 and Comparative Examples 7 to 9 were similarly heat-treated under heating conditions of 330°C and 20 minutes (LMP value=11,800). The obtained electrolytic copper foils to which the polyimide films were bonded and the copper plating layers were etched with the circuit patterns shown in FIG. 4A, then, as shown in FIG. 4B, 25 $\mu$m thick polyimide cover films were press bonded to the circuit forming surfaces, leaving aside the current-carrying parts, under the heating conditions of 300°C and 20 minutes (LMP value=11,200) to thereby obtain IPC flex test samples. The obtained test samples were tested by IPC flex tests under the following conditions, then the rate of increase of the electrical resistance from an initial state was measured. The results of the IPC flex test are described in Table 5.

Test equipment: SEK-31B-2S made by Shin-Etsu Engineering Co., Ltd.
Flex radius: 2.0 mm
Vibrating stroke width: 20 mm
Flex speed: 1500 times/minute

The measurement results are shown in Table 3, Table 4, and Table 5.

Table 3

| | | | | | | Surface roughness | | | |
| | Strength ratio against copper in SIMS analysis (%) | | | | | Matte-side surface of electrolytic copper foil or surface of copper plating layer | | Shiny-side surface of electrolytic copper foil or surface of non-electrolytic copper plating layer | |
| | Cl | N | S | O | C | Ra ($\mu$m) | Rz ($\mu$m) | Ra ($\mu$m) | Rz ($\mu$m) |
|---|---|---|---|---|---|---|---|---|---|
| Ex. 1 | 0.24 | 0 | 0 | 0.53 | 0.07 | 0.13 | 0.55 | 0.21 | 1.65 |
| Ex. 2 | 0.21 | 0 | 0.002 | 0.42 | 0.06 | 0.11 | 0.45 | 0.23 | 1.55 |
| Ex. 3 | 0.15 | 0 | 0 | 0.55 | 0.06 | 0.10 | 0.50 | 0.20 | 1.50 |
| Ex. 4 | 0.16 | 0 | 0 | 0.49 | 0.06 | 0.12 | 0.55 | 0.23 | 1.45 |
| Ex. 5 | 0.14 | 0 | 0 | 0.51 | 0.06 | 0.12 | 0.55 | 0.22 | 1.45 |
| Ex. 6 | 0.17 | 0 | 0 | 0.43 | 0.07 | 0.13 | 0.60 | 0.24 | 1.55 |
| Ex. 7 | 0.21 | 0 | 0.002 | 0.62 | 0.05 | 0.11 | 0.50 | 0.23 | 1.60 |
| Ex.14 | 0.31 | 0 | 0.003 | 0.40 | 0.06 | 0.14 | 0.65 | 0.19 | 1.30 |
| Ex. 15 | 0.29 | 0.002 | 0.003 | 0.42 | 0.05 | 0.08 | 0.65 | 0.18 | 1.35 |
| Ex. 16 | 0.33 | 0 | 0 | 0.39 | 0.05 | 0.08 | 0.55 | 0.18 | 1.35 |
| Ex. 17 | 0.35 | 0 | 0.003 | 0.35 | 0.04 | 0.11 | 0.65 | 0.19 | 1.30 |
| Ex. 18 | 0.31 | 0.002 | 0.002 | 0.33 | 0.06 | 0.10 | 0.65 | 0.18 | 1.25 |
| Ex. 19 | 0.29 | 0 | 0.003 | 0.39 | 0.05 | 0.11 | 0.60 | 0.18 | 1.30 |
| Ex. 20 | 0.38 | 0 | 0 | 0.44 | 0.05 | 0.09 | 0.55 | 0.17 | 1.35 |
| Comp. Ex. 1 | 1.71 | 0.008 | 0.010 | 2.14 | 0.09 | 0.17 | 1.25 | 0.23 | 1.60 |

(continued)

| | Strength ratio against copper in SIMS analysis (%) | | | | | Surface roughness | | | |
|---|---|---|---|---|---|---|---|---|---|
| | | | | | | Matte-side surface of electrolytic copper foil or surface of copper plating layer | | Shiny-side surface of electrolytic copper foil or surface of non-electrolytic copper plating layer | |
| | Cl | N | S | O | C | Ra (μm) | Rz (μm) | Ra (μm) | Rz (μm) |
| Comp. Ex. 2 | 2.13 | 0.013 | 0.014 | 1.23 | 0.07 | 0.17 | 1.30 | 0.24 | 1.55 |
| Comp. Ex. 3 | 0.26 | 0 | 0 | 0.49 | 0.07 | 0.25 | 1.40 | 0.24 | 1.45 |
| Comp. Ex. 7 | 2.48 | 0.010 | 0.015 | 1.66 | 0.07 | 0.14 | 1.15 | 0.17 | 1.35 |
| Comp. Ex. 8 | 2.77 | 0.014 | 0.016 | 1.53 | 0.06 | 0.14 | 1.05 | 0.18 | 1.30 |
| Comp. Ex. 9 | 0.30 | 0 | 0 | 0.43 | 0.07 | 0.22 | 1.45 | 0.19 | 1.35 |
| * Intensity average value of less than 0.5 is below lower limit of detection, so in that case the intensity ratio is indicated as "0". | | | | | | | | | |

Table 4

| | LMP value | Percentage of the crystal grains of lengths of 10 µm or more (%) | Tensile test | | Vickers hardness (Hv) |
|---|---|---|---|---|---|
| | | | 0.2% proof stress (kN/cm$^2$) | Young's modulus (kN/cm$^2$) | |
| Ex. 1 | 11500 | 91 | 5.9 | 1500 | |
| Ex. 2 | 11500 | 95 | 4.8 | 1400 | |
| Ex. 3 | 11500 | 93 | 4.8 | 1300 | |
| Ex. 4 | 11500 | 96 | 5.6 | 1500 | |
| Ex. 5 | 11500 | 93 | 5.9 | 1500 | |
| Ex. 6 | 11500 | 91 | 4.5 | 1300 | |
| Ex. 7 | 11500 | 94 | 5.8 | 1500 | |
| Ex. 8 | 10500 | 88 | 8.2 | 1800 | |
| Ex. 9 | 10500 | 90 | 7.5 | 1700 | |
| Ex. 10 | 10500 | 91 | 7.5 | 1700 | |
| Ex. 11 | 9500 | 75 | 9.2 | 1900 | |
| Ex. 12 | 9500 | 81 | 8.9 | 1800 | |
| Ex. 13 | 9500 | 80 | 8.8 | 1800 | |

| | | | | | |
|---|---|---|---|---|---|
| Ex. 14 | 11500 | 92 | | | 52 |
| Ex. 15 | 11500 | 93 | | | 51 |
| Ex. 16 | 11500 | 90 | | | 52 |
| Ex. 17 | 11500 | 91 | | | 53 |
| Ex. 18 | 11500 | 92 | | | 53 |
| Ex. 19 | 11500 | 93 | | | 53 |
| Ex. 20 | 11500 | 89 | | | 52 |
| Ex. 21 | 10500 | 89 | | | 55 |
| Ex. 22 | 10500 | 88 | | | 56 |
| Ex. 23 | 10500 | 87 | | | 55 |
| Ex. 24 | 9500 | 76 | | | 58 |
| Ex. 25 | 9500 | 79 | | | 57 |
| Ex. 26 | 9500 | 80 | | | 58 |
| Comp. Ex. 1 | 11500 | 13 | 15.2 | 3500 | |
| Comp. Ex. 2 | 11500 | 17 | 14.9 | 3300 | |
| Comp. Ex. 3 | 11500 | 42 | 9.5 | 2500 | |
| Comp. Ex. 4 | 8100 | 3 | 23.2 | 4500 | |
| Comp. Ex. 5 | 8100 | 2 | 24.0 | 4800 | |
| Comp. Ex. 6 | 8100 | 5 | 22.9 | 4400 | |
| Comp. Ex. 7 | 11500 | 10 | | | 92 |
| Comp. Ex. 8 | 11500 | 15 | | | 93 |
| Comp. Ex. 9 | 11500 | 39 | | | 65 |
| Comp. Ex. 10 | 8100 | 3 | | | 105 |
| Comp. Ex. 11 | 8100 | 3 | | | 103 |
| Comp. Ex. 12 | 8100 | 5 | | | 106 |

Table 5

| | LMP value | IPC flex test | |
| --- | --- | --- | --- |
| | | Rate of resistance increase at 10,000 times (%) | Rate of resistance increase at 50,000 times (%) |
| Ex. 1 | 11800 | 2 | 4 |
| Ex. 2 | | 2 | 4 |
| Ex. 3 | | 2 | 3 |
| Ex. 4 | | 2 | 4 |
| Ex. 5 | | 3 | 5 |
| Ex. 6 | | 1 | 3 |
| Ex. 7 | | 2 | 4 |
| Ex. 14 | | 3 | 6 |
| Ex. 15 | | 2 | 5 |
| Ex. 16 | | 2 | 5 |
| Ex. 17 | | 2 | 5 |
| Ex. 18 | | 2 | 4 |
| Ex. 19 | | 3 | 6 |
| Ex. 20 | | 2 | 5 |
| Comp. Ex. 1 | | 12 | subsidiary fracture |
| Comp. Ex. 2 | | 14 | subsidiary fracture |
| Comp. Ex. 3 | | 4 | 15 |
| Comp. Ex. 7 | | 14 | subsidiary fracture |
| Comp. Ex. 8 | | 13 | subsidiary fracture |
| Comp. Ex. 9 | | 3 | 13 |

As clear from Table 3, in all examples, there are few impurity elements of chlorine (Cl), nitrogen (N), sulfur (S), oxygen (O), and carbon (C) inside the electrolytic copper foils and the copper plating layers. Specifically, in intensity ratio with copper (Cu), chlorine is less than 0.5%, nitrogen is less than 0.005%, sulfur is less than 0.005%, oxygen is less than 1%, and carbon is less than 0.1%. The surface roughnesses show low degrees of roughness of an Ra of less than 0.3 $\mu$m and Rz of less than 2.0 $\mu$m at the matte-side surface. Further, as clear from Table 4, in all examples, after the heat treatment giving an LMP value of 9000 or more, the percentage of the crystal grains of a length of 10 $\mu$m or more (crystal distribution) is 70% or more. Furthermore, the 0.2% proof stresses of the electrolytic copper foils were less than 10 kN/cm$^2$, and the Young's moduli were less than 2000 kN/cm$^2$. The Vickers hardness of the copper plating layers was less than 60Hv. These all satisfied the requirements of the present invention. Furthermore, as clear from Table 5, the electrolytic copper foils and the copper plating layers showed good flexing characteristics as compared with the comparative examples.

On the other hand, the electrolytic copper foils and the copper plating layers of Comparative Examples 1 to 3 and Comparative Examples 7 to 9 shown in Table 3 and Table 4, even if giving values satisfactory in the amounts of impurity elements or surface roughnesses, had percentages of crystal grains of a length of 10 $\mu$m or more (crystal distribution) of less than 70% after heat treatment of 300°C and 1 hour giving an LMP value of 9000 or more. Furthermore, the 0.2% proof stresses of the electrolytic copper foils were 10 kN/cm$^2$ or more or the Young's moduli were 2000kN/cm$^2$ or more. The Vickers hardness of the copper plating layers was 60Hv or more. These did not satisfy all of the conditions of the present invention. Furthermore, as clear from Table 5, the electrolytic copper foils and the copper plating layers showed poor flexing characteristics as compared with the examples.

Further, the electrolytic copper foils and the copper plating layers of Comparative Examples 4 to 6 and Comparative Examples 10 to 12 shown in Table 3 and Table 4, even if giving values satisfactory in the amounts of impurity elements or surface roughnesses, had percentages of crystal grains of a length of 10 $\mu$m or more (crystal distribution) of less than 70% after heat treatment of 130°C and 1 hour giving an LMP value of less than 9000. Furthermore, the 0.2% proof stresses of the electrolytic copper foils were 10 kN/cm$^2$ or more or the Young's moduli were 2000kN/cm$^2$ or more. The Vickers hardness of the copper plating layers was 60Hv or more. These did not satisfy the conditions of the present invention.

Industrial Applicability

The electrolytic copper coating, the method of manufacturing the same, and the copper electrolyte for manufacturing an electrolytic copper coating of the present invention can be applied to a copper plating layer provided on a substrate in a printed circuit board, a multilayer printed circuit board, and a chip-on-film circuit board, a copper plating layer provided on a metal wire, or an electrolytic copper foil.

Reference Signs List

1: Anode
2: Cathode
3: Electrolyte
4: Untreated electrolytic copper foil

**Claims**

1. An electrolytic copper coating produced by electrolytic deposition, wherein, when performing heat treatment so that the LMP (Larson-Miller parameter) value shown in Equation 1 becomes 9000 or more, the result becomes a crystal distribution of crystal grains, having a maximum length of crystal grains after heat treatment of 10 $\mu$m or more, of 70% or more:

$$\text{Equation 1: LMP = (T+273)*(20+Logt)}$$

where, 20 is a material constant of copper, T is temperature (°C), and t is time (hr).

2. The electrolytic copper coating according to claim 1, wherein when the electrolytic copper coating is heat treated to give an LMP value of 9000 or more, the 0.2% proof stress of the electrolytic copper coating is less than 10 kN/cm$^2$, and the Young's modulus is less than 2000 kN/cm$^2$.

3. The electrolytic copper coating according to claim 1, wherein when the electrolytic copper coating is heat treated to give an LMP value of 9000 or more, the Vickers hardness of the electrolytic copper coating is less than 60Hv.

4. The electrolytic copper coating according to any one of claims 1 to 3, wherein the electrolytic copper coating, in SIMS (secondary ion mass spectrometry) analysis in the copper coating depth direction, in terms of the strength ratio with the copper (Cu), has a content of chlorine (Cl) of less than 0.5%, a content of nitrogen (N) of less than 0.005%, and a content of sulfur (S) of less than 0.005%.

5. The electrolytic copper coating according to any one of claims 1 to 4, wherein a roughness of at least one surface of the electrolytic copper coating is less than 0.30 $\mu$m in terms of Ra and less than 2.0 $\mu$m in terms of Rz.

6. A method of manufacturing an electrolytic copper coating produced by electrolytic deposition using a copper electrolyte, wherein, when performing heat treatment so that the LMP value shown in Equation 1 becomes 9000 or more, the result becomes a crystal distribution of crystal grains, having a maximum length of crystal grains after heat treatment of 10 $\mu$m or more, of 70% or more.

**Equation 1: LMP = (T+273)*(20+Logt)**

where, 20 is a material constant of copper, T is temperature (°C), and t is time (hr).

7. The method of manufacturing the electrolytic copper coating according to claim 6, wherein the copper electrolyte contains at least one type of reaction product of at least one type of di- or poly-halogenated chain saturated aliphatic hydrocarbon compound, at least one type of di- or poly-halogenated chain saturated aliphatic hydrocarbon compound which has one or more ether bonds, or a combination of at least one type of di- or poly-halogenated chain saturated aliphatic hydrocarbon compound and at least one type of di- or poly-halogenated chain saturated aliphatic hydrocarbon compound which has one or more ether bonds with a heterocyclic compound which has two nitrogen atoms.

8. The method of manufacturing the electrolytic copper coating according to claim 6 or 7, wherein the copper electrolyte contains at least one type of reaction product of at least one type of di- or poly-halogenated chain saturated aliphatic hydrocarbon compound, at least one type of di- or poly-halogenated chain saturated aliphatic hydrocarbon compound which has one or more ether bonds, or a combination of at least one type of di- or poly-halogenated chain saturated aliphatic hydrocarbon compound and at least one type of di- or poly-halogenated chain saturated aliphatic hydrocarbon compound which has one or more ether bonds with a heterocyclic compound which has two nitrogen atoms and contains at least one type of brightener.

9. The method of manufacturing the electrolytic copper coating according to any one of claims 6 to 8, wherein the heterocyclic compound which has two nitrogen atoms is a heterocyclic aromatic compound which has two nitrogen atoms.

10. A copper electrolyte for manufacturing an electrolytic copper coating, containing at least one type of reaction product of a di- or poly-halogenated chain saturated aliphatic hydrocarbon compound or a di- or poly-halogenated chain saturated aliphatic hydrocarbon compound which has one or more ether bonds with a heterocyclic compound which has two nitrogen atoms and contains at least one type of brightener.

11. A copper electrolyte for manufacturing an electrolytic copper coating, containing at least one type of reaction product of at least one type of di- or poly-halogenated chain saturated aliphatic hydrocarbon compound, at least one type of di- or poly-halogenated chain saturated aliphatic hydrocarbon compound which has one or more ether bonds, or a combination of at least one type of di- or poly-halogenated chain saturated aliphatic hydrocarbon compound and at least one type of di- or poly-halogenated chain saturated aliphatic hydrocarbon compound which has one or more ether bonds with a heterocyclic compound which has two nitrogen atoms.

12. A copper electrolyte for manufacturing an electrolytic copper coating, containing at least one type of reaction product of at least one type of di- or poly-halogenated chain saturated aliphatic hydrocarbon compound, at least one type of di- or poly-halogenated chain saturated aliphatic hydrocarbon compound which has one or more ether bonds, or a combination of at least one type of di- or poly-halogenated chain saturated aliphatic hydrocarbon compound and at least one type of di- or poly-halogenated chain saturated aliphatic hydrocarbon compound which has one or more ether bonds with a heterocyclic compound which has two nitrogen atoms and contains at least one type of brightener.

FIG.1

## FIG.2A

EXAMPLE1

LMP＝11500

## FIG.2B

COMPARATIVE
EXAMPLE1

LMP＝11500

## FIG.3A

EXAMPLE1

## FIG.3B

COMPARATIVE EXAMPLE1

# FIG.4A

CIRCUIT PATTERN OF IPC
FLEX TEST SAMPLE

# FIG.4B

IPC FLEX TEST SAMPLE

## INTERNATIONAL SEARCH REPORT

| | International application No. |
|---|---|
| | PCT/JP2009/060792 |

A. CLASSIFICATION OF SUBJECT MATTER
C25D1/04(2006.01)i, C25D1/00(2006.01)i, C25D3/38(2006.01)i

According to International Patent Classification (IPC) or to both national classification and IPC

B. FIELDS SEARCHED

Minimum documentation searched (classification system followed by classification symbols)
C25D1/04, C25D1/00, C25D3/38

Documentation searched other than minimum documentation to the extent that such documents are included in the fields searched
Jitsuyo Shinan Koho          1922–1996   Jitsuyo Shinan Toroku Koho   1996–2009
Kokai Jitsuyo Shinan Koho    1971–2009   Toroku Jitsuyo Shinan Koho   1994–2009

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| Y | JP 52-7819 A  (The Furukawa Electric Co., Ltd.), 21 October, 1977 (21.10.77), Page 1, right column (Family: none) | 1–12 |
| Y | JP 2004-35918 A  (Nippon Denkai Ltd.), 05 February, 2004 (05.02.04), Claims (Family: none) | 1–12 |
| Y | JP 2007-146289 A  (Mitsui Mining & Smelting Co., Ltd.), 14 June, 2007 (14.06.07), Claims & WO 2007/052630 A1     & KR 10-2008-0064884 A & CN 101297067 A          & US 2009/0166213 A | 1–12 |

☒  Further documents are listed in the continuation of Box C.          ☐   See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered   to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| 30 September, 2009 (30.09.09) | 13 October, 2009 (13.10.09) |

| Name and mailing address of the ISA/ Japanese Patent Office | Authorized officer |
|---|---|
| Facsimile No. | Telephone No. |

Form PCT/ISA/210 (second sheet) (April 2007)

**INTERNATIONAL SEARCH REPORT**

| International application No. |
|---|
| PCT/JP2009/060792 |

C (Continuation).    DOCUMENTS CONSIDERED TO BE RELEVANT

| Category* | Citation of document, with indication, where appropriate, of the relevant passages | Relevant to claim No. |
|---|---|---|
| A | WO 2004/059040 A1  (Nikko Materials Co., Ltd.),<br>15 July, 2004 (15.07.04),<br>Claims<br>& CN 1564881 A           & EP 1607495 A1<br>& US 2006/0011488 A1    & HK 1068654 A<br>& TW 285683 B            & US 2008/0075972 A1<br>& JP 4083171 B | 1-12 |
| A | JP 2004-250777 A  (Shipley Co., L.L.C.),<br>09 September, 2004 (09.09.04),<br>Claims<br>& EP 1371757 A1           & CN 1497069 A | 1-12 |
| A | JP 2006-57177 A  (C. Uyemura & Co., Ltd.),<br>02 March, 2006 (02.03.06),<br>Claims<br>& KR 10-2006-0053951 A  & US 2006/0207886 A1<br>& CN 1900377 A | 1-12 |

Form PCT/ISA/210 (continuation of second sheet) (April 2007)